# EUROPEAN PATENT APPLICATION

(11) **EP 4 570 969 A1**
(43) Date of publication of application: **18.06.2025**
(21) Application number: 23862527.1
(22) Date of filing: 08.09.2023
(51) Int. Cl.: C30B 15/22, C30B 15/26, C30B 29/06, C30B 15/00

(54) **PREPARATION METHOD FOR CZOCHRALSKI SINGLE CRYSTAL, AND SINGLE CRYSTAL FURNACE**

(30) Priority: 09.09.2022 CN 202211103909
(71) Applicant: Zhonghuan Advanced Semiconductor Technology Co., Ltd., Wuxi, Jiangsu 214203 (CN)
(72) Inventor: HUANG, Mo, Wuxi, Jiangsu 214203 (CN); CHEN, Chun-hung, Wuxi, Jiangsu 214203 (CN)
(74) Representative: Studio Torta S.p.A.
(86) International application number: PCT/CN2023/117794
(87) International publication number: WO 2024/051833

(57) **Abstract**

A preparation method for a Czochralski single crystal, and a single crystal furnace. The preparation method for the Czochralski single crystal includes: forming a meniscus at an interface between a melt and a growing single crystal; measuring a width of the meniscus by a measurement apparatus; and determining a temperature of the melt according to the width of the meniscus, wherein the melt is a solution formed by melting a raw material filled in a crucible, and a growth process of the single crystal includes a necking stage, a shouldering stage, a body stage, and a tailing stage.

## Description

### Priority Information

This application claims priority to Chinese Patent Application No. 202211103909.0, filed to the China National Intellectual Property Administration on September 09, 2022 and entitled "Preparation Method for Czochralski Single Crystal, and Single Crystal Furnace", the disclosure of which is hereby incorporated by reference in its entirety.

### Technical Field

The present invention relates to the field of semiconductors, and in particular, to a preparation method for a Czochralski (CZ) single crystal, and a single crystal furnace.

### Background

In a growth process of a crystal of a CZ method (Czochralski method) single crystal furnace, a silicon material is melted in a crucible, and a seed crystal is immersed in a melt and pulled from the melt, and after the dislocation is eliminated, a pulled single crystal grows at a lower end of the seed crystal. Due to capillary action, the melt is adsorbed at a phase boundary of an edge of the single crystal by surface tension to form a meniscus. In the growth process of the crystal, latent heat is released at a solid-liquid interface, so that the meniscus is brighter than a free liquid surface of the melt, a circle of bright meniscus is shown, and a width of the meniscus is related to a temperature of the melt. In the existing growth process of the single crystal by a Czochralski method, the temperature of the melt is determined by observing the width of the meniscus with human eyes. Since the width of the meniscus is constantly changing, there is a deviation in a reading process.

Therefore, the existing preparation method for a Czochralski single crystal still needs to be further improved.

### Summary

The present invention aims to solve one of the technical problems in the related art at least to some extent.

One aspect of the present invention provides a preparation method for a Czochralski single crystal, including: forming a meniscus at an interface between a melt and a growing single crystal; measuring a width of the meniscus by a measurement apparatus; and determining a temperature of the melt according to the width of the meniscus. The melt is a solution formed by melting a raw material filled in a crucible, and a growth process of the single crystal includes a necking stage, a shouldering stage, a body stage, and a tailing stage. Therefore, the width of the meniscus can be determined more accurately, so as to accurately control the temperature of the melt to reach a preset temperature for the growth of the single crystal, improve the preparation efficiency of the single crystal, and improve the repeatability of the process.

According to some embodiments of the present invention, in the necking stage, immersing a seed crystal in the melt, the meniscus is formed at an interface between the seed crystal and the melt, and confirming the temperature of the melt according to the width of the meniscus.

According to some embodiments of the present invention, in the necking process, when the actual width of the meniscus is greater than a preset width, increasing the temperature of the melt; and when the actual width is less than the preset width, decreasing the temperature of the melt.

According to some embodiments of the present invention, in the shouldering stage, adjusting the temperature of the melt according to an actual diameter of the single crystal at different positions.

According to some embodiments of the present invention, in the shouldering stage, an actual diameter of the single crystal is d, and satisfies d= (d₁+d₂)/2, wherein d₁ is an inner-side diameter of the meniscus obtained by the measurement apparatus, and d₂ is an outer-side diameter of the meniscus obtained by the measurement apparatus.

According to some embodiments of the present invention, the shouldering stage further includes: obtaining the width of the meniscus by the measurement apparatus, and determining the actual diameter d at fixed time intervals, and keeping a change rate of the actual diameter d consistent.

According to some embodiments of the present invention, when an actual change rate of the actual diameter is greater than a preset value, increasing a pulling rate of the single crystal; when the change rate of the actual diameter is less than the preset value, decreasing the pulling rate of the single crystal.

According to some embodiments of the present invention, in the body stage, determining the temperature of the melt according to an actual width of the meniscus.

According to some embodiments of the present invention, in the body stage, a preset width of the meniscus is a constant value, and when the actual width of the meniscus is greater than the preset width, increasing the temperature of the melt; and when the actual width of the meniscus is less than the preset width, decreasing the temperature of the melt.

According to some embodiments of the present invention, in the body stage, an actual diameter of the single crystal is D, and satisfies D= (D₁+D₂)/2, wherein D₁ is an inner-side diameter of the meniscus obtained by the measurement apparatus, and D₂ is an outer-side diameter of the meniscus obtained by the measurement apparatus.

According to some embodiments of the present invention, in the body stage, when the actual diameter of the single crystal is greater than a preset diameter, increasing the pulling rate of the single crystal; and when the actual diameter of the single crystal is less than the preset diameter, decreasing the pulling rate of the single crystal.

Another aspect of the present invention provides a single crystal furnace, including a furnace chamber, an accommodating space being defined in the furnace chamber, a furnace cover being arranged above the furnace chamber, and the furnace cover being provided with a measurement apparatus; a quartz crucible, the quartz crucible being arranged in the accommodating space to melt a raw material and accommodate a melt, a space capable of vertically moving a seed crystal being arranged above the quartz crucible, the seed crystal being vertically movably arranged above the quartz crucible and being capable of extending into the melt to grow a single crystal, and the measurement apparatus being configured to measure a width of a meniscus formed at an interface between the melt and the single crystal; a pulling apparatus, being configured to control a pulling rate of the single crystal; a heating apparatus, corresponding to the quartz crucible; and a control unit, which can receive a signal fed back by the measurement apparatus to start or stop the heating apparatus and the pulling apparatus. Therefore, according to the single crystal furnace, in the preparation process of the Czochralski single crystal, the width of the meniscus at a lower end of the single crystal can be obtained by the measurement apparatus, and then the temperature of the melt in the necking and body stages is determined. At the same time, the width of the meniscus is obtained by the measurement apparatus to determine the diameter of the single crystal in the body stage, thereby reducing a diameter deviation of the single crystal finally formed and improving the preparation efficiency of the single crystal.

### Brief Description of the Drawings

The above and/or additional aspects and advantages of the present invention will become apparent and easy to understand from the accompanying drawings below with reference to the description of the embodiments.
Fig. 1 shows a schematic diagram of a preparation method for a Czochralski single crystal according to one embodiment of the present invention.
Fig. 2 shows a flowchart of a preparation method for a Czochralski single crystal according to one embodiment of the present invention.
Fig. 3 shows a schematic diagram of a relationship between a pulling rate and a necking length in a necking process according to one embodiment of the present invention.
Fig. 4 shows a schematic diagram of a width of a meniscus below a single crystal according to one embodiment of the present invention.
Fig. 5 shows a schematic diagram of a crystal crown part in a shouldering stage according to one embodiment of the present invention.

### Detailed Description of the Embodiments

Embodiments of the present invention are described in detail below. The embodiments described below are exemplary and are only used to explain the present invention, and are not to be construed as limiting the present invention. If no specific techniques or conditions are specified in the embodiments, the techniques or conditions described in the literature in this field or the product specification is followed. If the manufacturer of the reagents or instruments used is not indicated, they are all conventional products that may be obtained commercially. The reagents or instruments used without indicating the manufacturer are conventional products that may be commercially purchased.

One aspect of the present invention provides a preparation method for a Czochralski single crystal, forming a meniscus at an interface between a melt and a growing single crystal; measuring a width of the meniscus by a measurement apparatus; and determining a temperature of the melt according to the width of the meniscus. Wherein, the melt is a solution formed by melting a raw material filled in a crucible, and a growth process of the single crystal includes a necking stage, a shouldering stage, a body stage, and a tailing stage. Therefore, the width of the meniscus can be determined more accurately, so as to accurately control the temperature of the melt to reach a preset temperature for the growth of the single crystal, improve the preparation efficiency of the single crystal, and improve the repeatability of the process.

The principle that the present invention can achieve the above beneficial effects is described in detail below.

In the growth process of the single crystal, the temperature of the melt can be confirmed by the width of the meniscus. For example, when the temperature of the melt is close to a melting point (about 1420 °C) of the single crystal, the width of the meniscus is about 2 mm. If the width of the meniscus is determined by naked eye observation, on the one hand, because the width of 2 mm is relatively small, when the width range of the meniscus is too large or too small to be perceived by human eyes, it is mistakenly believed that the width of the meniscus has reached 2 mm, and then believed that the temperature of the melt has reached the preset temperature during the growth of the single crystal. Therefore, the temperature for each growth of the single crystal can be different, resulting in poor reproducibility of the process and different process representation in the growth process of the single crystal. On the other hand, personnel also need to monitor the situation of the meniscus in real time in the growth process of the single crystal and are difficult to perceive that the meniscus reaches the preset width in real time, resulting in misjudgment or delay in adjusting the temperature of the melt. In addition, the width of the meniscus is related to the pulling rate of the single crystal in the body stage. For example, when the meniscus is 2 mm, the pulling rate of the single crystal of 100 mm can slowly rise to 4 mm/min. However, if necking is performed when the meniscus is 1.5 mm, the pulling rate of the single crystal of 100 mm can slowly rise to only 3.7 mm/min. Since the crystal growth is a cumulative process, the difference in the early necking process can have a greater impact on the subsequent shouldering and body stages, such as the occurrence of wire breakage and defect distribution. In the present invention, the width of the meniscus is read by the measurement apparatus, which not only avoids errors during reading, but also ensures that the growth is performed when the width of the meniscus is the preset width in each production stage of the growth of the single crystal, thereby improving the reproducibility of the growth process of the single crystal, reducing the probability of wire breakage of the single crystal to a certain extent, and improving the crystallization rate and production efficiency of the single crystal.

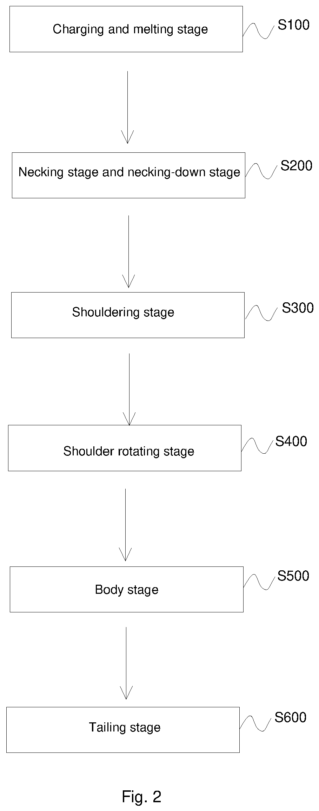

Various processes of the preparation method for the Czochralski single crystal are described in detail below. Referring to Fig. 2, the method includes the following operations.

### S100, a charging and melting stage

In this process, a polycrystalline material is placed in the quartz crucible, and after the polycrystalline material is melted, a temperature stabilization process is entered. In the temperature stabilization process, the temperature in the furnace is measured by a high-temperature detector above the single crystal furnace.

According to some embodiments of the present invention, after entering the temperature stabilization process, the power of a main heater in the crystal growth furnace is gradually decreased to the power required at the beginning of necking, and the power of a bottom heater in the crystal growth furnace is also gradually decreased. Specifically, the power of the bottom heater can be reduced from 25 kw to 5 kw, and at the same time, the position of the quartz crucible is gradually raised from a zero position, so that a distance from a liquid surface of the melt to a flow guide tube reaches a target value.

### S200, a necking stage and a necking-down stage

In this process, a dislocation-free single crystal is obtained by a thin neck pulling growth technique (i.e., Dash technique). Specifically, the seed crystal is immersed in the melt, the meniscus is formed at the interface between the seed crystal and the melt, the temperature of the melt is determined based on the actual width of the meniscus, and then a single crystal with a relatively small diameter is pulled out of the melt. For example, a <111> seed crystal or a <100> seed crystal can be used.

According to some embodiments of the present invention, in order to reduce a temperature difference between the seed crystal and the melt, the seed crystal can be preheated before necking. Specifically, a distance between a lower end of the seed crystal and the melt can be 15 mm to 25 mm, and a preheating time can be 10 min to 20 min. Therefore, when the seed crystal is immersed in the melt, the seed crystal is prevented from generating thermal shock because the temperature of the seed crystal is much lower than the temperature of the melt, thereby avoiding generating dislocation on the seed crystal to reduce the adverse effect on the growth of the single crystal.

According to some embodiments of the present invention, in the necking stage, the meniscus is generated after the seed crystal is immersed in the melt, the meniscus is captured by the measurement apparatus to determine the actual width of the meniscus, and when the actual width of the meniscus is the preset width, it can be considered that the temperature of the melt has reached the appropriate temperature for necking. Further, in order to avoid unstable temperature of the melt, the actual width of the meniscus is continuously obtained by the measurement apparatus at certain time intervals, an average value of the actual widths of multiple meniscuses is calculated continuously, and when a measured value of the actual width of the meniscus deviates slightly from the average value, that is, the temperature of the melt is relatively stable, necking can be started.

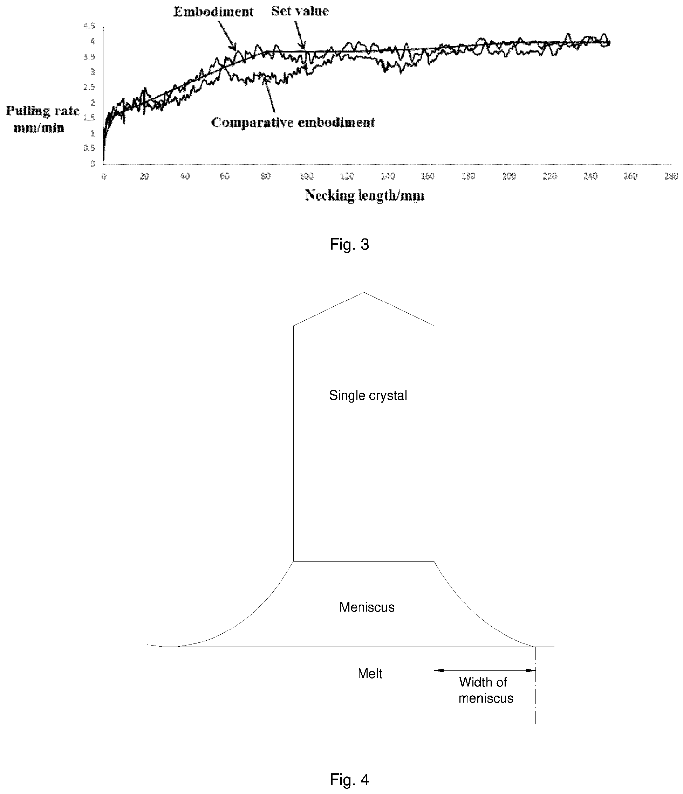

It is to be noted that the width of the meniscus referred to here is a horizontal distance between surface heights of a phase boundary and the melt outside the meniscus (referring to Fig. 4). Generally, a brightness threshold is set in the above measurement apparatus, an area above the threshold is a white area, i.e., the meniscus, and an area below the threshold is a black area.

It is to be noted that the type of the measurement apparatus is not particularly limited and can be a camera, a video recorder, etc.

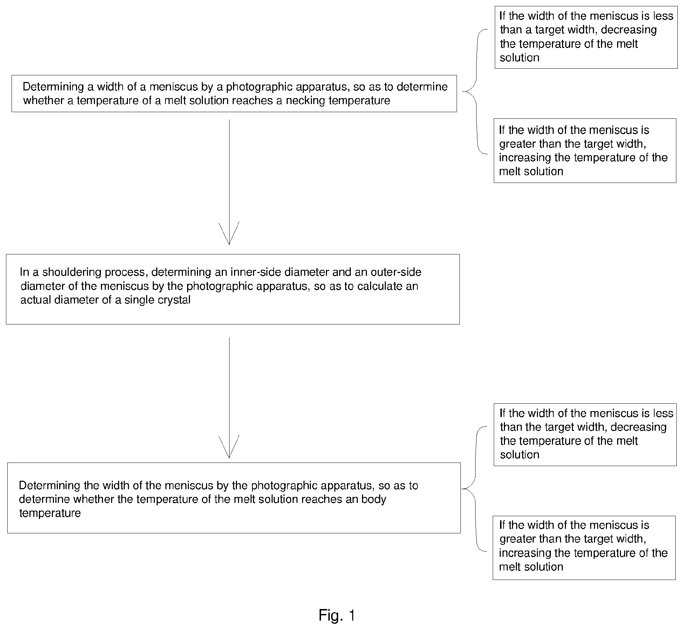

According to some embodiments of the present invention, in the necking process, since the temperature of the melt is close to the melting point of the single crystal, at this time, the preset width of the meniscus is a certain value. According to different structures of the single crystal furnaces, the preset width of the corresponding meniscus can be 2 mm, 2.1 mm, or 2.2 mm. Referring to Fig. 1, when the actual width of the meniscus obtained by the measurement apparatus is greater than the preset width, the heating power needs to be adjusted to increase the temperature of the melt, so that the temperature of necking remains basically the same; and when the actual width of the meniscus obtained by the measurement apparatus is less than the preset width, the heating power needs to be adjusted to decrease the temperature of the melt, so that the temperature of necking remains basically the same. The actual width of the meniscus is monitored in real time by the measurement apparatus to accurately feedback a temperature value of the melt. In the existing production, when the seed crystal is in contact with the melt, if it is melted instantly, it indicates that the temperature of the melt is too high and the temperature needs to be decreased; and if the diameter of the single crystal grows rapidly, it indicates that the temperature is relatively low and the temperature needs to be increased. As stated above, in actual production, research personnel only determine whether the temperature of the melt needs to be increased or decreased according to the observed situation, but cannot confirm whether it has been adjusted to the appropriate temperature. Therefore, in the present invention, the actual width of the meniscus is obtained by the measurement apparatus, so that the width of the meniscus is close to the preset value in each crystal necking process, thereby ensuring that the temperature of the melt is basically the same and remains stable in each crystal necking process, achieving the repeatability of the process in the production process, and improving the production efficiency.

According to some embodiments of the present invention, the width of the meniscus is determined by the measurement apparatus in the necking process, so that the pulling rate in the necking process can be closer to a set value. Referring to Fig. 3, the embodiment is to determine the width of the meniscus by the camera, and the comparative embodiment is to determine the width of the meniscus by human eye observation. As can be seen from the figure, the width of the meniscus is accurately determined by the camera in real time, then it is determined that the temperature of the melt is basically the same and remains stable, and then necking is performed, thereby ensuring that the pulling rate in the necking process can be closer to the set value, and improving the repeatability of the production process.

According to some embodiments of the present invention, when a 12-inch single crystal is pulled, in order to prevent the thin neck crystal from breaking with the increase of the weight of the single crystal in the pulling process, thereby causing the entire single crystal to fall, the diameter of the thin neck can be set to 4 mm to 6 mm in the necking process, preferably, the diameter of the thin neck is 4.5 mm; the length of the thin neck can be set to 180 mm to 350 mm, preferably, the length of the thin neck is 200 mm; and the growth rate when pulling the thin neck is 3.5 mm/min to 4.5 mm/min.

### S300, a shouldering stage

After the necking stage is completed, the diameter of the single crystal needs to be expanded to a preset diameter (the preset diameter is the diameter in the body stage), that is, the shouldering stage is entered. The diameter of the single crystal in the shouldering stage is constantly changing.

Specifically, in the shouldering stage, the temperature of the melt is adjusted according to an actual diameter of the single crystal at different positions. If the actual diameter deviates from the preset diameter, the actual diameter can be made close to the preset diameter by adjusting the temperature of the melt. For example, when the actual diameter of the single crystal is too large, increasing the temperature of the melt; and when the diameter of the single crystal is too small, decreasing the temperature of the melt. In the cooling process, cooling parameters can be adjusted to reduce the problem of wire breakage. Therefore, the reading accuracy is improved by the measurement apparatus in the reading process of the actual diameter of the single crystal. Further, in the growth process of the single crystal, the actual diameter of the single crystal is made closer to the preset diameter of the single crystal by adjusting the temperature of the melt, thereby further ensuring that the actual diameter of the single crystal remains stable in multiple shouldering processes, improving the repeatability of the process in the production process, improving the crystallization rate of the crystal, and improving the production efficiency. According to some embodiments of the present invention, when a 12-inch single crystal is pulled, it generally takes 3h to 5h for the actual diameter of the single crystal to increase to the preset diameter, and the temperature of the melt needs to be strictly controlled in the shouldering process.

Further, the actual diameter of the single crystal is d, and satisfies d= (d₁+d₂)/2, wherein d₁ is an inner-side diameter of the meniscus obtained by the measurement apparatus, and d₂ is an outer-side diameter of the meniscus obtained by the measurement apparatus. For example, when the inner-side diameter of the meniscus is 119 and the outer-side diameter of the meniscus is 120 mm, the actual diameter of the single crystal is 119.5 mm. Therefore, the influence of the change of the width of the meniscus on the reading of the diameter of the single crystal can be avoided. Therefore, the inner-side diameter and the outer-side diameter of the meniscus are accurately obtained by the measurement apparatus, so that reading errors can be reduced, the actual diameter of the single crystal can be closer to the preset value, and it can be ensured that the actual diameter of the single crystal remains stable in multiple shouldering processes, thereby improving the repeatability of the process in the production process, improving the crystallization rate of the crystal, and improving the production efficiency.

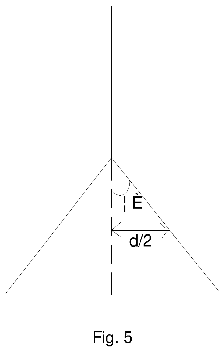

According to some embodiments of the present invention, the shouldering stage further includes: obtaining the width of the meniscus by the measurement apparatus, and determining the actual diameter d at fixed time intervals, and keeping a change rate of the actual diameter d consistent. Specifically, referring to Fig. 5, in the shouldering stage, as the single crystal is pulled, the single crystal gradually grows to form a crystal crown part. It can be understood by those skilled in the art that an angle θ shown in the figure is related to the diameter (d/2) of the single crystal and the pulling rate (affecting the length of the other right-angled side of the angle θ). Here, in order to keep the repeatability of the production process and the consistency of the shape of the crystal crown, the width of the meniscus can be monitored, and the relevant production parameters in the shouldering stage can be adjusted to control the angle θ to remain unchanged, that is, the shape of the crystal crown remains consistent. Specifically, a change rate of the diameter of the single crystal can be first obtained: in a case that the pulling rate is kept constant, the width of the meniscus can be first obtained by the measurement apparatus to determine the actual diameter dₐ, and after a period of time, the width of the meniscus is obtained by the measurement apparatus to determine the actual diameter d_{b}, and the change rate of the diameter of the single crystal is d_{b}-dₐ; after the same period of time, the width of the meniscus is obtained by the measurement apparatus to determine the actual diameter d_{c} of the single crystal, and at this time, the change rate of the diameter of the single crystal is d_{c}-d_{b}. At this time, if the determined d_{b}-dₐ and d_{c}-d_{b} are the same, that is, the angle θ in Fig. 5 is unchanged, then the crystal crown of the same shape can be obtained. When the determined d_{b}-dₐ and d_{c}-d_{b} are different, the aforementioned step of obtaining the change rate of the diameter of the single crystal can be repeated by adjusting the process parameters, so that the determined d_{b}-dₐ and d_{c}-d_{b} are kept consistent. By keeping the change rate of the diameter of the single crystal stable, the repeatability of the process is improved, and it is ensured that the shape of the crystal crown is the same each time the single crystal grows.

According to some embodiments of the present invention, when the change rate of the actual diameter is greater than the preset value, that is, the increase of the actual diameter is relatively fast, in order to keep the same angle θ, the too fast change of the actual diameter needs to be balanced by increasing the pulling rate of the single crystal; and when the change rate of the actual diameter is less than the preset value, that is, the increase of the actual diameter is relatively slow, in order to keep the same angle θ, the too slow change of the actual diameter needs to be balanced by decreasing the pulling rate of the single crystal. Then, when the change rate of the actual diameter of the single crystal deviates from the preset value, the appropriate adjusted pulling rate can be calculated by a controller, thereby obtaining a crystal crown of the same shape. Therefore, the repeatability of the process is improved, and the production efficiency is improved.

According to some specific embodiments of the present invention, when the diameter of the single crystal is increased rapidly, the width of the meniscus is relatively small, and the inner-side diameter of the meniscus can be directly identified as the diameter of the single crystal.

### S400, a shoulder rotating stage

When the diameter of the single crystal reaches the preset diameter, the shoulder rotating process is entered, in the shoulder rotating process, the pulling rate of the single crystal is increased, and in order to prevent the diameter of the single crystal from continuing to decrease after the shoulder rotating, a cooling treatment can be performed at the beginning of the shoulder rotating. According to some embodiments of the present invention, if the diameter of the single crystal continues to decrease in the shoulder rotating process, it indicates that the cooling amplitude is too large; and if the diameter of the single crystal continues to increase, it indicates that the cooling amplitude is too small. Further, the pulling rate can be adjusted to avoid continuous increase or continuous decrease of the single crystal.

### S500, a body stage

After the shoulder rotating is completed, the diameter of the single crystal can be stabilized at the preset diameter, and the body stage is entered.

According to some embodiments of the present invention, in the body stage, the width of the meniscus is increased, and the measurement apparatus takes pictures regularly to obtain the actual width of the meniscus, thereby determining the temperature of the melt. Specifically, in the body growth process of the single crystal, the temperature of the melt corresponds to the width of the meniscus, and the width of the meniscus is obtained by the measurement apparatus, so that the temperature of the melt can be known. Therefore, the actual width of the meniscus is obtained by the measurement apparatus, so that the reading errors can be reduced, and the width of the meniscus in each body process is close to the preset value, thereby ensuring that the temperature of the melt in each body process is more stable, and the deviation between the actual diameter of the single crystal and the preset diameter is smaller, and the process repeatability in the production process is high, and the production efficiency is improved.

According to some embodiments of the present invention, referring to Fig. 1, in the body process, the preset width of the meniscus is a constant value. When the actual width of the meniscus is greater than the preset width, it indicates that the temperature of the melt is relatively low and the temperature of the melt can be increased until the measurement apparatus measures that the actual width of the meniscus is relatively close to the preset width, indicating that the temperature of the melt at this time basically reaches the preset temperature of the body growth of the single crystal; and similarly, when the actual width of the meniscus is less than the preset width, it indicates that the temperature of the melt is relatively high and the temperature of the melt can be reduced until the actual width of the meniscus is measured to be close to the preset width, indicating that the temperature of the melt at this time is very close to or has reached the preset temperature of the body growth of the single crystal. Therefore, the actual temperature of the melt is closer to the preset temperature of the melt, and the repeatability of the process in the production process is improved to obtain a single crystal with a smaller deviation between the actual diameter and the preset diameter, thereby improving the production efficiency. The understanding that the preset width of the meniscus is the constant value is that in the body stage of the Czochralski single crystal, as the production proceeds, the amount of melt in the crucible is decreased, and some production process parameters change, such as the power of the heating apparatus and the position of the quartz crucible, so that the preset width values of the meniscus at different lengths in the body stage are slightly different. For example, when entering the body stage, the preset width of the meniscus is 2 mm. As the amount of melt in production decreases, the preset width of the meniscus at different lengths changes slightly, and can be 1.9 mm or 1.8 mm.

According to some embodiments of the present invention, in the body process, the actual diameter of the single crystal is D, and satisfies D= (D₁+D₂)/2, wherein D₁ is the inner-side diameter of the meniscus obtained by the measurement apparatus, and D₂ is the outer-side diameter of the meniscus obtained by the measurement apparatus. Therefore, the inner-side diameter and the outer-side diameter of the meniscus are obtained by the measurement apparatus, so that the actual diameter of the single crystal in the body stage is obtained, the influence of the change of the width of the meniscus on the reading of the diameter of the single crystal is avoided, the reading errors can be reduced, the actual diameter of the single crystal can be closer to the preset value, and it can be ensured that the actual diameter of the single crystal in the body stage remains stable, thereby improving the repeatability of the process in the production process, and improving the crystallization rate of the crystal and the production efficiency.

It is understandable that the inner-side diameter and outer-side diameter of the meniscus are obtained by the measurement apparatus, thereby obtaining the actual diameter D of the single crystal in the body stage, and the width of the meniscus is the difference between the outer-side diameter and the inner-side diameter, and the width of the meniscus corresponds to the temperature of the melt, that is, the width of the meniscus determines the temperature of the melt, which indicates that the actual diameter D of the single crystal in the body stage can indirectly determine the temperature of the melt, that is, the corresponding relationship is D=D1+(D2-D1)/2=D1+width of the meniscus/2.

According to some embodiments of the present invention, if the actual diameter D of the single crystal in the body stage deviates from the preset diameter, the actual diameter can be made closer to the preset diameter by adjusting the temperature of the melt. However, in the actual production process, the temperature of the melt is adjusted by using the heating apparatus, but there is always a certain hysteresis. In order to avoid this hysteresis, the actual diameter of the single crystal can be adjusted by adjusting the pulling rate of the single crystal while keeping the temperature of the melt unchanged. Specifically, when the actual diameter of the single crystal is greater than the preset diameter, increasing the pulling rate of the single crystal until the actual diameter of the single crystal obtained by the measurement apparatus is close to the preset diameter; and when the actual diameter of the single crystal is less than the preset diameter, decreasing the pulling rate of the single crystal until the actual diameter of the single crystal obtained by the measurement apparatus is close to the preset diameter. Therefore, not only the accuracy of the reading of the actual diameter of the single crystal is improved, but also the actual diameter of the single crystal is made to approach the preset diameter relatively quickly, thereby further keeping the stability of the actual diameter of the single crystal in the body stage, improving the repeatability of the process in the production process, and improving the crystallization rate of the crystal and the production efficiency.

### S600, a tailing stage

The end of crystal growth mainly prevents the reverse extension of dislocation. Generally, the distance of reverse extension of the dislocation of the crystal is greater than or equal to the diameter of the crystal growth. Therefore, when the length of crystal growth reaches the predetermined requirement, the diameter of the crystal should be gradually decreased to finally become a point and leave the melt surface.

In summary, the preparation method proposed in the present invention uses the measurement apparatus to monitor the width of the meniscus in each production stage, thereby ensuring that the temperature of the melt corresponding to each necking stage and body stage of multiple single crystal productions is the same, and the shape of the crystal crown in the shouldering stage is the same, thereby improving the repeatability of the production process and the production efficiency.

The present invention further provides a single crystal furnace, which can meet the requirements for the preparation of the aforementioned method for single crystal preparation. Specifically, the single crystal furnace includes: a furnace chamber, an accommodating space being defined in the furnace chamber, a furnace cover being arranged above the furnace chamber, and the furnace cover being provided with a measurement apparatus; a quartz crucible, the quartz crucible being arranged in the accommodating space to melt a raw material and accommodate a melt, a space capable of vertically moving a seed crystal being arranged above the quartz crucible, the seed crystal being vertically movably arranged above the quartz crucible and being capable of extending into the melt to grow a single crystal, and the measurement apparatus being configured to measure a width of a meniscus formed at an interface between the melt and the single crystal; a pulling apparatus, being configured to control a pulling rate of the single crystal; a heating apparatus, corresponding to the quartz crucible; and a control unit, which can receive a signal fed back by the measurement apparatus to start or stop the heating apparatus and the pulling apparatus. Therefore, according to the single crystal furnace, in the preparation process of the Czochralski single crystal, the width of the meniscus on the crystal can be obtained by the measurement apparatus, and then the temperature of the melt in the necking and body stages is determined, thereby avoiding the deviation caused by reading with human eyes, and reducing the probability of wire breakage of the single crystal to a certain extent. At the same time, the width of the meniscus is obtained by the measurement apparatus to determine the diameter of the single crystal in the body stage, thereby reducing the deviation in the reading of the diameter of the single crystal and improving the preparation efficiency of the single crystal.

In Embodiment 1 and Embodiment 2, the inner-side diameter and the outer-side diameter of the meniscus are obtained by the camera to calculate the actual diameter of the single crystal; and in Comparative Embodiment 1 and Comparative Embodiment 2, the diameter of the single crystal is obtained by observing the width of the meniscus with human eyes. Specific results are shown in Table 1.

The diameter is set to 310 mm, and the actual diameters of the Embodiments and Comparative Embodiments in the body stage are as follows.

**Table 1**

| Body position | Embodiment 1 | Embodiment 2 | Comparative Embodiment 1 | Comparative Embodiment 2 |
|---|---|---|---|---|
| 50 | 310.83 | 311.46 | 312.9 | 310.7 |
| 100 | 311.25 | 311.9 | 310.64 | 311.8 |
| 150 | 310.78 | 311.29 | 309.97 | 308.8 |
| 200 | 310.23 | 310.71 | 309.87 | 308.9 |
| 250 | 310.1 | 310.42 | 309.35 | 308.6 |
| 300 | 309.83 | 310.84 | 309.7 | 308.7 |
| 350 | 310.25 | 311.18 | 311.52 | 308.2 |
| 400 | 310.18 | 310.06 | 308.93 | 307.83 |
| 450 | 310.51 | 310 | 310.18 | 308.95 |
| 500 | 310.46 | 309.74 | 310.06 | 308.41 |
| 550 | 311.15 | 310.34 | 310.08 | 309.08 |
| 600 | 310.16 | 310.97 | 309.56 | 309.44 |
| 650 | 309.29 | 310.79 | 309.21 | 309.75 |
| 700 | 309.88 | 310.72 | 308.63 | 309.44 |
| 750 | 310.69 | 311.48 | 309.5 | 310.03 |
| 800 | 310.99 | 311.03 | 309.68 | 307.77 |
| 850 | 311.18 | 310.35 | 311.65 | 308.42 |
| 900 | 310.69 | 310.61 | 310.57 | 311.05 |
| 950 | 310.86 | 310.64 | 310.81 | 309.03 |
| 1000 | 310.95 | 310.62 | 310.63 | 309.09 |
| 1050 | 311 | 311.56 | 310.24 | 309.52 |
| 1100 | 311.29 | 311.8 | 310.33 | 309.26 |
| 1150 | 310.29 | 310.85 | 310.29 | 309.95 |
| 1200 | 310.27 | 310.63 | 310.25 | 309.71 |
| 1250 | 309.95 | 311.36 | 310.02 | 309.98 |
| 1300 | 309.71 | 311.02 | 310.36 | 310.9 |
| 1350 | 309.91 | 310.82 | 311.58 | 311.97 |
| Average diameter | 310±1.3 | 310±1.9 | 310±2.9 | 310±2.2 |

It can be seen from the above table that in the body stage, the width of the meniscus is determined by the camera, then the temperature of the melt is determined, and after body growth, the diameter deviation of the crystal obtained is smaller.

The embodiments of the present invention are described above in conjunction with the accompanying drawings. However, the present invention is not limited to the above-mentioned specific implementations. The above specific implementations are merely illustrative rather than restrictive. Under the inspiration of the present invention, various forms may be made by those of ordinary skill in the art without departing from the conception of the present invention, and all fall within the protection of the present invention.

## Claims

1. A preparation method for a Czochralski single crystal, wherein: forming a meniscus at an interface between a melt and a growing single crystal; measuring a width of the meniscus by a measurement apparatus; and determining a temperature of the melt according to the width of the meniscus;
wherein the melt is a solution formed by melting a raw material filled in a crucible; and
a growth process of the single crystal comprises a necking stage, a shouldering stage, a body stage, and a tailing stage.

2. The method according to claim 1, wherein, in the necking stage, immersing a seed crystal in the melt, the meniscus is formed at an interface between the seed crystal and the melt, and confirming the temperature of the melt according to an actual width of the meniscus.

3. The method according to claim 2, wherein, when the actual width of the meniscus is greater than a preset width of the meniscus, increasing the temperature of the melt; and when the actual width is less than the preset width, decreasing the temperature of the melt.

4. The method according to any one of claims 1 to 3, wherein, in the shouldering stage, adjusting the temperature of the melt according to an actual diameter of the single crystal at different positions.

5. The method according to any one of claims 1 to 4, wherein, in the shouldering stage, an actual diameter of the single crystal is d, and satisfies d= (d₁+d₂)/2, wherein d₁ is an inner-side diameter of the meniscus obtained by the measurement apparatus, and d₂ is an outer-side diameter of the meniscus obtained by the measurement apparatus.

6. The method according to claim 4 or 5, wherein the shouldering stage further comprises: obtaining the width of the meniscus by the measurement apparatus, and determining the actual diameter d at fixed time intervals, and keeping a change rate of the actual diameter d consistent.

7. The method according to any one of claims 4 to 6, wherein, when a change rate of the actual diameter is greater than a preset value, increasing a pulling rate of the single crystal; and when the change rate of the actual diameter is less than the preset value, decreasing the pulling rate of the single crystal.

8. The method according to any one of claims 1 to 7, wherein, in the body stage, determining the temperature of the melt according to an actual width of the meniscus.

9. The method according to claim 8, wherein, in the body stage, a preset width of the meniscus is a constant value, and when the actual width of the meniscus is greater than the preset width, increasing the temperature of the melt; and when the actual width of the meniscus is less than the preset width, decreasing the temperature of the melt.

10. The method according to claim 8 or 9, wherein, in the body stage, an actual diameter of the single crystal is D, and satisfies D= (D₁+D₂)/2, wherein D₁ is an inner-side diameter of the meniscus obtained by the measurement apparatus, and D₂ is an outer-side diameter of the meniscus obtained by the measurement apparatus.

11. The method according to claim 10, wherein, in the body stage, when the actual diameter of the single crystal is greater than a preset diameter, increasing a pulling rate of the single crystal; and when the actual diameter of the single crystal is less than the preset diameter, decreasing the pulling rate of the single crystal.

12. A single crystal furnace, comprising:
a furnace chamber, wherein an accommodating space is defined in the furnace chamber, a furnace cover is arranged above the furnace chamber, and the furnace cover is provided with a measurement apparatus;
a quartz crucible, wherein the quartz crucible is arranged in the accommodating space to melt a raw material and accommodate a melt, a space capable of vertically moving a seed crystal is arranged above the quartz crucible, the seed crystal is vertically movably arranged above the quartz crucible and is capable of extending into the melt to grow a single crystal, and the measurement apparatus is configured to measure a width of a meniscus formed at an interface between the melt and the single crystal;
a pulling apparatus, being configured to control a pulling rate of the single crystal;
a heating apparatus, corresponding to the quartz crucible; and
a control unit, which can receive a signal fed back by the measurement apparatus to start or stop the heating apparatus and the pulling apparatus.
